(19) Europäisches Patentamt
European Patent Office
Office européen des brevets

(11) **EP 3 776 677 B1**

(12) **FASCICULE DE BREVET EUROPEEN**

(45) Date de publication et mention de la délivrance du brevet:
**16.02.2022 Bulletin 2022/07**

(21) Numéro de dépôt: **19715974.2**

(22) Date de dépôt: **13.03.2019**

(51) Classification Internationale des Brevets (IPC):
*H01L 41/43* *(2013.01)*  *H01L 41/08* *(2006.01)*
*H01L 41/319* *(2013.01)*  *H03H 3/007* *(2006.01)*
*H03H 9/72* *(2006.01)*

(52) Classification Coopérative des Brevets (CPC):
**H01L 41/0815; H01L 41/319; H01L 41/43;
H03H 3/10; H03H 9/02228; H03H 9/02559;
H03H 9/02574; H03H 9/02834**

(86) Numéro de dépôt international:
**PCT/FR2019/050540**

(87) Numéro de publication internationale:
**WO 2019/186011 (03.10.2019 Gazette 2019/40)**

(54) **STRUCTURE HYBRIDE POUR DISPOSITIF A ONDES ACOUSTIQUES DE SURFACE ET PROCEDE DE FABRICATION ASSOCIE**

HYBRIDSTRUKTUR FÜR OBERFLÄCHENSCHALLWELLENVORRICHTUNG UND ZUGEHÖRIGES HERSTELLUNGSVERFAHREN

HYBRID STRUCTURE FOR SURFACE ACOUSTIC WAVE DEVICE AND ASSOCIATED PRODUCTION METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.03.2018 FR 1852796**

(43) Date de publication de la demande:
**17.02.2021 Bulletin 2021/07**

(60) Demande divisionnaire:
**21217508.7**

(73) Titulaire: **SOITEC
38190 Bernin (FR)**

(72) Inventeurs:
• **ALLIBERT, Frédéric
38100 GRENOBLE (FR)**
• **VEYTIZOU, Christelle
38190 BERNIN (FR)**

(74) Mandataire: **IP Trust
2, rue de Clichy
75009 Paris (FR)**

(56) Documents cités:
**FR-A1- 3 047 355      US-A- 6 117 341
US-A1- 2014 091 677**

**Description**

**DOMAINE DE L'INVENTION**

La présente invention concerne le domaine des dispositifs à ondes acoustiques de surface. Elle concerne en particulier une structure hybride adaptée pour la fabrication de dispositifs à ondes acoustiques de surface.

**ARRIERE PLAN TECHNOLOGIQUE DE L'INVENTION**

Les structures de résonateurs acoustiques tels que les dispositifs à ondes acoustiques de surface (« SAW » pour « Surface Acoustic Wave » selon la terminologie anglo-saxonne) utilisent un ou plusieurs transducteurs interdigités élaborés sur un substrat piézoélectrique pour convertir des signaux électriques en ondes acoustiques et vice versa. De tels dispositifs ou résonateurs SAW sont souvent utilisés dans les applications de filtrage. La technologie SAW à radiofréquences (RF) fournit d'excellentes performances telles qu'une haute isolation et de faibles pertes d'insertion. Pour cette raison, elle est utilisée pour les duplexeurs RF dans les applications de communication sans fil.

L'amélioration des performances des dispositifs SAW RF, passe notamment par l'obtention d'une réponse en fréquence stable vis-à-vis de la température. La dépendance de la fréquence de fonctionnement des dispositifs SAW vis-à-vis de la température, ou le coefficient de fréquence thermique (« TCF » pour « Température Coefficient of Frequency »), dépend d'une part des variations de l'espacement entre les électrodes interdigitées des transducteurs, qui sont généralement dues aux coefficients de dilatation thermique (« CTE » pour « Coefficient of Thermal Expansion ») relativement élevés des substrats piézoélectriques utilisés ; d'autre part, le TCF dépend du coefficient de vitesse thermique car la dilatation ou la contraction du substrat piézoélectrique s'accompagne d'une augmentation ou d'une diminution de la vitesse de l'onde acoustique de surface. Pour minimiser le coefficient de fréquence thermique (TCF), un objectif est donc de minimiser la dilatation/contraction du substrat piézoélectrique, notamment dans la zone de surface dans laquelle les ondes acoustiques vont se propager.

L'article de K.Hashimoto, M.Kadota et al, « Recent development of temperature compensated SAW devices », IEEE Ultrason. Symp. 2011, pages 79 à 86, 2011, donne une vue d'ensemble des approches couramment utilisées pour surmonter le problème de dépendance, vis-à-vis de la température, de la réponse en fréquence des dispositifs SAW.

Une approche intéressante consiste à utiliser un substrat hybride, par exemple composé d'une couche de matériau piézoélectrique disposée sur un substrat de silicium. Le CTE faible du silicium permet de limiter la dilatation/contraction de la couche piézoélectrique en température. Dans le cas d'une couche piézoélectrique de Tantalate de Lithium (LiTaO3), l'article précédemment cité indique qu'un ratio de 10 entre l'épaisseur de LiTaO3 et l'épaisseur du substrat de silicium permet d'améliorer convenablement le coefficient de fréquence thermique (TCF). L'un des inconvénients de cette approche vient de la présence d'ondes acoustiques parasites (appelées « spurious acoustic modes » dans l'article « Characterization of bonded wafer for RF filters with reduced TCF », B.P.Abbott et al, Proc 2005 IEEE International Ultrasonics Symposium, Sept 19-21, 2005, pp.926-929) qui impactent négativement les caractéristiques en fréquence du résonateur élaboré sur le substrat hybride. Ces résonances parasites sont notamment liées à des réflexions parasites de l'onde acoustique principale (se propageant principalement dans une zone superficielle de la couche de LiTaO3) sur les interfaces sous-jacentes, dont notamment l'interface entre le LiTaO3 et le silicium. Une solution pour diminuer ces résonances parasites est d'augmenter l'épaisseur de la couche de LiTa03 ; cela supposant d'augmenter également l'épaisseur du substrat de Si pour conserver les améliorations du TCF, l'épaisseur totale du substrat hybride n'est plus compatible avec les besoins de réduction d'épaisseur des composants finaux, notamment pour adresser le marché des téléphones cellulaires. Une autre solution, proposée par K.Hashimoto et al. (Article précédemment cité) est de rugosifier la surface inférieure de la couche de LiTaO3 (à l'interface de collage avec le substrat) de façon à limiter les réflexions de l'onde acoustique sur celle-ci. Un autre exemple se trouve dans le brevet US2014/0091677.

**OBJET DE L'INVENTION**

Un objet de la présente invention est de proposer une solution alternative aux solutions de l'état de l'art. Un objet de l'invention est notamment de proposer une structure hybride permettant la réduction et/ou l'élimination desdites ondes acoustiques parasites.

**BREVE DESCRIPTION DE L'INVENTION**

La présente invention concerne une structure hybride pour dispositif à ondes acoustiques de surface comprenant une couche utile de matériau piézoélectrique assemblée à un substrat support présentant un coefficient de dilatation thermique inférieur à celui de la couche utile, et une couche intermédiaire située entre la couche utile et le substrat support. La structure hybride est remarquable en ce que la couche intermédiaire est une couche composite frittée, formée à partir de poudres d'au moins un premier matériau et un deuxième matériau différent du premier.

Selon des caractéristiques avantageuses de l'invention, prises seules ou en combinaison :

- le premier matériau présente une impédance acoustique similaire à celle de la couche utile ; le rapport entre l'impédance acoustique de la couche utile et l'impédance acoustique du deuxième matériau est supérieur à 2 ; et la taille moyenne des particules des poudres du premier et du deuxième matériau est supérieure ou égale au quart de la longueur d'onde du signal acoustique destiné à se propager en surface du dispositif à ondes acoustiques de surface.

- le premier matériau et le deuxième matériau sont choisis de manière à former une couche d'adaptation d'impédance acoustique entre la couche utile et le substrat support ; la taille moyenne des particules des poudres du premier et du deuxième matériau est inférieure au quart de la longueur d'onde du signal acoustique destiné à se propager en surface du dispositif à ondes acoustiques de surface.

- le substrat support comprend un matériau choisi parmi le silicium, le verre, la silice, le saphir, l'alumine, le nitrure d'aluminium.

- la couche utile comprend un matériau piézoélectrique choisi parmi le tantalate de lithium (LiTaO3),le niobate de lithium (LiNbO3), le quartz, l'oxyde de zinc (ZnO).

- les premier et deuxième matériaux sont choisis parmi l'oxyde de silicium, le nitrure de silicium, le silicium, le carbure de silicium, l'alumine, le germanium, le sapphire, le zirconium.

- la couche composite présente une épaisseur comprise entre quelques centaines de nanomètres et plusieurs dizaines de microns.

L'invention concerne également un procédé de fabrication d'une structure hybride pour un dispositif à ondes acoustiques de surface comprenant les étapes suivantes :

i) La fourniture d'une couche utile de matériau piézoélectrique et d'un substrat support présentant un coefficient de dilatation thermique inférieur à celui de la couche utile ;

ii) Le dépôt d'une couche formée d'un mélange de poudres d'au moins un premier matériau et un deuxième matériau différent du premier, sur une première face de la couche utile et/ou sur une première face du substrat support ;

iii) Le frittage de la couche formée du mélange de poudres pour obtenir une couche composite frittée solidaire de la première face de la couche utile et/ou de la première face du substrat support ;

iv) L'assemblage de la couche utile et du substrat support, de sorte que la couche composite soit disposée entre la couche utile et le substrat support.

Selon des caractéristiques avantageuses de l'invention, prises seules ou en combinaison :

- la première face de la couche utile et/ou la première face du substrat support comporte une couche de protection, préalablement au dépôt de la couche formée du mélange de poudres de l'étape ii).
- la couche de protection est formée par au moins un matériau choisi parmi le nitrure de silicium, un oxynitrure de silicium, un oxyde de silicium et l'alumine.
- le mélange de poudres se présente sous la forme d'une pate visqueuse, et le dépôt de la couche formée par ledit mélange à l'étape ii) est réalisé par enduction centrifuge.
- le dépôt de la couche formée par le mélange de poudres est suivi d'un traitement thermique à basse température pour évacuer au moins un composant liquide de la pate visqueuse.
- une couche de collage est déposée sur la couche composite frittée, préalablement à l'étape iv) d'assemblage.
- la couche utile fournie à l'étape i) est un substrat donneur de matériau piézoélectrique.
- le procédé de fabrication comprend une étape v) d'amincissement du substrat donneur jusqu'à l'épaisseur souhaitée de la couche utile pour la fabrication du dispositif à ondes acoustiques.

## BREVE DESCRIPTION DES DESSINS

D'autres caractéristiques et avantages de l'invention ressortiront de la description détaillée qui va suivre en référence aux figures annexées sur lesquelles :

- la figure 1 présente une structure hybride conforme à l'invention ;
- le tableau la présente une liste de matériaux adaptés pour former une couche composite frittée d'une structure hybride conforme à l'invention ;
- le tableau 1b présente une liste de matériaux pour former une couche utile d'une structure hybride conforme à l'invention ;
- les figures 2a et 2b présentent des structures hybrides conformes à l'invention ;
- la figure 3 présente une structure hybride conforme à l'invention, comportant un dispositif SAW ;
- les figures 4a à 4e présentent un procédé de fabrication d'une structure hybride conforme à l'invention.

## DESCRIPTION DETAILLEE DE L'INVENTION

Dans la partie descriptive, les mêmes références sur les figures pourront être utilisées pour des éléments de même nature. Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y.

L'invention concerne une structure hybride 10 adaptée pour la fabrication des dispositifs à ondes acoustiques de surface (SAW) ; elle est notamment adaptée à la fabrication de dispositifs dont la fréquence est comprise dans la gamme de quelques dizaines de MHz à quelques dizaines de GHz.

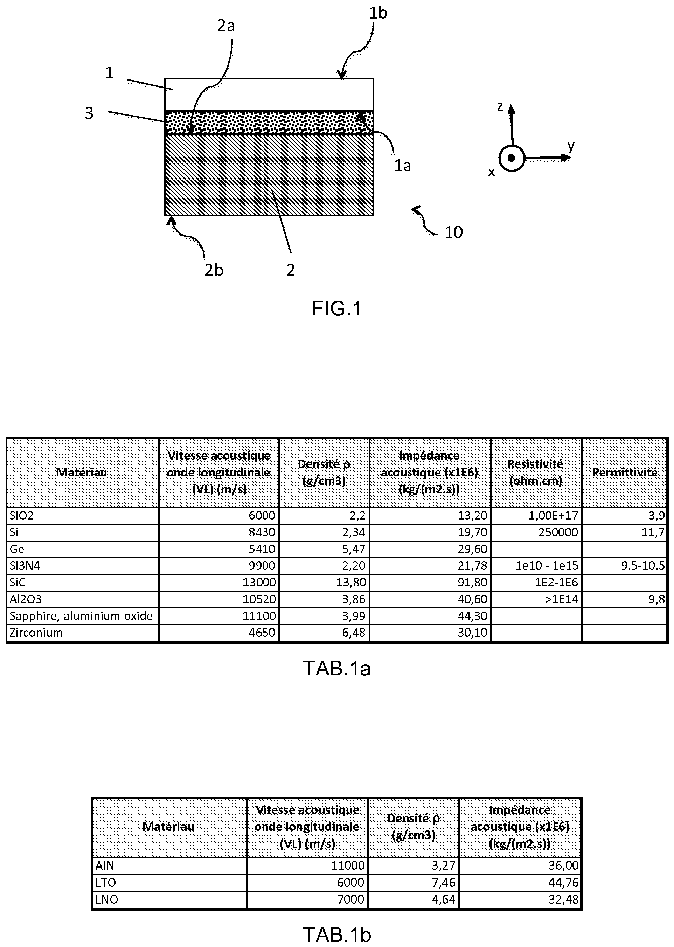

La structure hybride 10 selon l'invention comprend une couche utile 1 de matériau piézoélectrique, présentant une première face la et une seconde face 1b, comme illustré sur la figure 1. La couche utile 1 est ainsi nommée car elle sera utilisée pour l'élaboration ultérieure des dispositifs à ondes acoustiques de surface. A titre d'exemple, la couche utile 1 de la structure hybride 10 pourra être composée d'un matériau choisi dans le groupe : tantalate de lithium $LiTaO_3$ (LTO dans le tableau 1b), niobate de lithium $LiNbO_3$ (LNO dans le tableau 1b), nitrure d'aluminium AlN (tableau 1b), oxyde de zinc (ZnO).

La structure hybride 10 inclut également une couche intermédiaire 3 disposée sous la couche utile 1 (selon l'axe z représenté sur la figure 1). La couche intermédiaire est une couche composite frittée 3, formée à partir de poudres d'au moins deux matériaux différents. Par couche frittée, on entend une couche issue de la consolidation d'un mélange de poudres : cette consolidation est obtenue par apport d'énergie thermique et éventuellement mécanique, mais sans fusion d'au moins un des matériaux pulvérulents du mélange. Le caractère fritté de la couche composite peut donc être détecté par analyse structurale de ladite couche (par exemple par microscopie électronique à balayage). Les particules ou grains des poudres de matériaux apparaissent soudés entre eux et la densité de la couche composite dépend du niveau de compactage du mélange lors de l'apport d'énergie pour la consolidation.

Les particules formant la poudre de chacun des matériaux de la couche composite frittée 3 présentent des dimensions suivant une distribution typiquement gaussienne. Dans la suite de la description, la taille moyenne des particules sera assimilée au diamètre équivalent moyen des particules d'un matériau donné. La taille moyenne des particules peut typiquement varier entre quelques dizaines de nanomètres et quelques microns.

La couche composite frittée 3 est formée à partir d'au moins un premier et un deuxième matériau, choisis parmi l'oxyde de silicium, le nitrure de silicium, le silicium, le carbure de silicium, l'alumine, le germanium, le saphir, le zirconium, dont certaines propriétés sont indiquées dans le tableau 1.

La couche composite frittée 3 pourra éventuellement comprendre trois matériaux différents ou plus.

La couche composite frittée 3 présente, selon les modes de réalisation, une épaisseur comprise entre quelques centaines de nanomètres et plusieurs microns.

Enfin, la structure hybride 10 comprend un substrat support 2 présentant un coefficient de dilatation thermique inférieur à celui de la couche utile 1, disposé sous la couche composite 3 (selon l'axe z représenté sur la figure 1), permettant de limiter la dilatation/contraction de la couche utile 1 en température (et ainsi d'améliorer le coefficient de fréquence thermique des dispositifs qui seront élaborés sur ladite couche utile 1). Le substrat support 2 pourra notamment être composé d'un matériau choisi dans le groupe : silicium, semi-conducteurs III-V, carbure de silicium, verre, saphir.

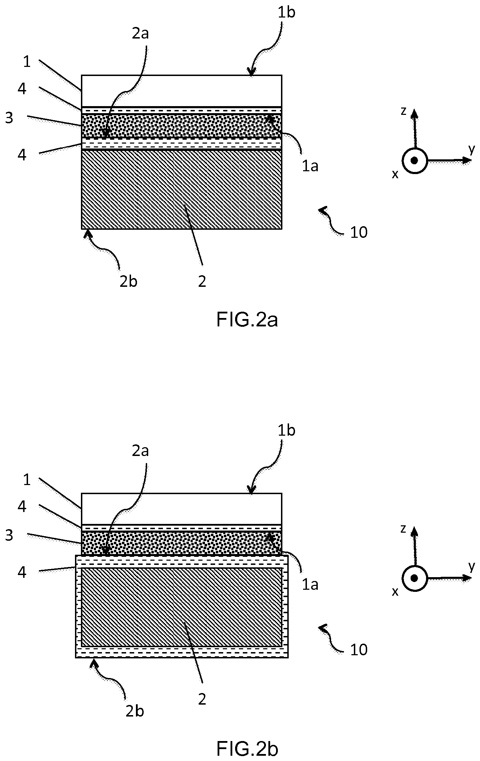

Comme illustré sur les figures 2a et 2b, la structure hybride 10 comprend préférentiellement des couches additionnelles 4 disposées sur la première face la de la couche utile 1 et/ou sur la première face 2a du substrat support 2, et potentiellement sur la deuxième face 2b du substrat support 2 et sur les tranches dudit substrat 2 (figure 2b). Comme nous le verrons lors de la description du procédé de fabrication de la structure hybride 10, ces couches additionnelles 4 ont notamment une fonction de protection du substrat support 2 et/ou de la couche utile 1, contre la diffusion d'impuretés contenues dans la couche composite frittée 3 ou présentes lors de l'élaboration de ladite couche 3.

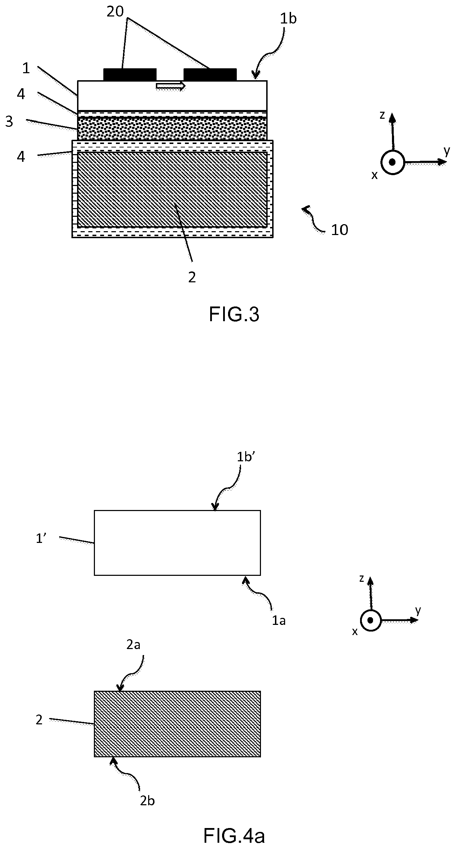

La structure hybride 10 selon l'invention est adaptée à la fabrication de dispositifs à ondes acoustiques de surface (SAW), comportant notamment des électrodes métalliques 20 sur la couche utile 1, entre lesquelles se propage un signal acoustique (schématisé par la flèche blanche sur la figure 3), dans le plan (x,y), à proximité de la surface de la deuxième face 1b de la couche utile 1.

Selon un premier mode de réalisation de la structure hybride 10 de l'invention, la couche composite frittée 3 est configurée pour maximiser la diffusion d'une onde acoustique incidente, issue du signal acoustique et qui se propagerait dans le volume de la couche utile 1, jusqu'à la couche composite 3.

Pour cela, dans la couche composite frittée 3, formée à partir de poudres d'au moins un premier et un deuxième matériau, le premier matériau présente une impédance acoustique similaire à celle de la couche utile 1. Par similaire, on entend présentant un écart maximum de +/- 20% autour de la valeur d'impédance acoustique de la couche utile 1, et préférentiellement un écart inférieur à +/-15%, voire +/-10%. A titre d'exemple, pour une couche utile 1 en LiTaO$_3$, le premier matériau peut être de l'alumine, dont l'impédance acoustique ($40.6 \times 10^6$ Pa.s/m) est sensiblement la même que celle du tantalate de lithium ($44.8 \times 10^6$ Pa.s/m).

De plus, le rapport entre l'impédance acoustique de la couche utile 1 et l'impédance acoustique du deuxième matériau de la couche composite frittée 3, est choisi supérieur ou égal à 2, de manière à garantir un coefficient de réflexion de plus de 10%. A titre d'exemple, si le premier matériau est du tantalate de lithium ($44.8 \times 10^6$ Pa.s/m), le deuxième matériau pourra être du SiO2, dont l'impédance acoustique est de $13.2 \times 10^6$ Pa.s/m, permettant d'obtenir un coefficient de réflexion de l'ordre de 30% à l'interface entre les particules de la couche composite 3, et produisant des réflexions dans de multiples directions (diffusion).

Enfin, la taille des particules des poudres du premier et du deuxième matériau est supérieure ou égale au quart de la longueur d'onde de l'onde acoustique incidente. Cette caractéristique assure que l'onde acoustique incidente puisse subir l'influence des particules. Par exemple, pour une onde acoustique incidente présentant une longueur d'onde autour de 6 microns (soit une fréquence d'environ 1 GHz), la taille moyenne des particules sera choisie autour de 2 microns. La couche composite frittée 3 présente alors une épaisseur supérieure à 5 microns, voire supérieure à 10 microns.

Si une couche additionnelle 4 est présente entre la couche utile 1 et la couche composite 3, la couche additionnelle 4 devra avoir une impédance acoustique proche de celle de la couche utile 1, pour limiter les réflexions parasites entre ces deux couches. Pour une couche utile 1 en LiTaO$_3$, on pourra par exemple utiliser de l'alumine dont l'impédance acoustique ($40.6 \times 10^6$ Pa.s/m) est proche de celle du LiTaO$_3$, ce qui conduit à une réflexion de moins de 0.5%.

La couche composite frittée 3 selon le premier mode de réalisation permet de diffuser l'onde incidente dans une multitude de directions, et limite ainsi grandement la composante réfléchie vers les électrodes 20 du dispositif à ondes acoustiques de surface.

Selon un deuxième mode de réalisation de la structure hybride 10 de l'invention, la couche composite frittée 3 est configurée pour maximiser la transmission d'une onde acoustique incidente, issue du signal acoustique et qui se propagerait dans le volume de la couche utile 1, jusqu'à la couche composite 3.

Pour cela, dans la couche composite frittée 3, formée à partir de poudres d'au moins un premier et un deuxième matériau, le premier matériau et le deuxième matériau sont choisis de manière à former une couche d'adaptation d'impédance acoustique entre la couche utile 1 et le substrat support 2. Former une couche d'adaptation d'impédance acoustique sous-entend que l'impédance acoustique moyenne de la couche composite 3 est sensiblement égale à la racine carrée du produit des impédances acoustiques de la couche utile 1 et du substrat support 2 :

$$Z_{couche\ composite} \cong \sqrt{Z_{couche\ utile} \times Z_{substrat}}$$

Rappelons que l'impédance acoustique Z d'un matériau s'exprime comme :

$$Z = v \times \rho$$

où $v$ est la vitesse de l'onde acoustique dans le matériau, $\rho$ est la densité du matériau.

Dans le cas de la couche composite 3, on considère les fractions volumiques $V_1$ et $V_2$ de chacun des matériaux la composant, on peut ainsi évaluer son impédance acoustique (dans le cas de deux matériaux) à partir de l'expression :

$$Z_{couche\ composite} = (v_1 \times V_1 + v_2 \times V_2) \times (\rho_1 \times V_1 + \rho_2 \times V_2)$$

où $\rho_1$ et $\rho_2$ sont respectivement la densité du premier et du deuxième matériau, $v_1$, et $v_2$ sont respectivement la vitesse de l'onde acoustique dans le premier et le deuxième matériau.

Les fractions volumiques $V_1$ et $V_2$ sont définies par la proportion de chacun des matériaux dans la couche composite 3.

A titre d'exemple, le premier matériau pourra être du Al$_2$O$_3$ et le deuxième matériau du SiO$_2$, présents dans la couche composite selon des proportions de 65% et 35% respectivement. L'impédance de la couche composite 3 pourra ainsi être de l'ordre de $30 \times 10^6$ Pa.s/m.

De plus, selon ce deuxième mode de réalisation, la taille moyenne des particules des poudres du premier et du deuxième matériau est inférieure au quart de la longueur d'onde de l'onde acoustique incidente. Cette caractéristique assure que l'onde acoustique incidente voit la couche composite comme un milieu quasiment homogène. A titre d'exemple, pour une onde acoustique incidente présentant une longueur d'onde autour de 7.5 microns (soit une fréquence d'environ 800 MHz), la taille moyenne des particules pourra être choisie autour de 0.5 microns. La couche composite frittée 3 pourra présenter une épaisseur de quelques microns.

Si une couche additionnelle 4 est présente entre la couche utile 1 et la couche composite 3, la couche additionnelle 4 devra avoir une impédance acoustique proche de celle de la couche utile 1, pour limiter les réflexions parasites entre ces deux couches. Pour une couche utile 1 en LiTaO$_3$, on pourra par exemple utiliser de l'alumine dont l'impédance acoustique ($40.6 \times 10^6$ Pa.s/m) est proche de celle du LiTaO$_3$, ce qui conduit à une réflexion de moins de 0.5%.

Si une couche additionnelle 4 est présente entre la couche composite 3 et le substrat support 2, cette couche additionnelle 4 devra avoir une impédance acoustique proche de celle du substrat support 2, pour limiter les réflexions parasites à l'interface couche additionnelle / substrat support. Pour un substrat support en Si, on pourra par exemple utiliser du nitrure de silicium dont l'impédance acoustique (~$22 \times 10^6$ Pa.s/m) est proche de celle du Si, ce qui conduit à une réflexion de moins de 0.5%.

La couche composite frittée 3 selon le deuxième mode de réalisation permet de privilégier la transmission (par adaptation d'impédance acoustique) de la couche utile 1 vers le substrat 2, de l'onde acoustique incidente se réfléchissant habituellement aux interfaces d'une structure hybride : elle permet donc de diminuer les réflexions parasites impactant négativement les caractéristiques en fréquence du dispositif SAW élaboré sur la structure hybride 10.

Selon une variante applicable aux différents modes de réalisation décrits de la structure hybride 10, la couche composite frittée 3 présente de bonnes propriétés diélectriques (résistivité supérieure à $1^E7$ohms.cm) et une permittivité équivalente faible (typiquement inférieure à 11 F/m, permittivité du silicium), de manière à procurer une isolation électrique équivalente à plusieurs microns d'oxyde de silicium. Une telle couche composite frittée 3 peut notamment améliorer la linéarité du dispositif à ondes acoustiques de surface dans le domaine de radiofréquences.

Selon une autre variante applicable aux différents modes de réalisation décrits de la structure hybride 10, la couche composite frittée 3 présente des propriétés de piégeage de charges électriques mobiles. Cette caractéristique permet de piéger et donc de neutraliser les charges électriques susceptibles d'apparaître dans la partie supérieure du substrat support 2 du fait de la présence de charges fixes dans l'une des couches supérieures (couche additionnelle 4 ou couche utile 1). Pour présenter cette caractéristique de piégeage, l'un des matériaux composant les particules de la couche composite 3 pourra être du silicium.

L'invention concerne également un procédé de fabrication d'une structure hybride 10 pour un dispositif à ondes acoustiques de surface. Le procédé comprend une première étape (notée i)) de fourniture d'une couche utile 1 de matériau piézoélectrique. Selon un mode de mise en œuvre avantageux, la couche utile 1 se présente sous la forme d'un substrat donneur 1' de matériau piézoélectrique, d'épaisseur et de diamètre standard pour l'industrie micro-électronique (figure 4a).

La première étape comporte également la fourniture d'un substrat support 2 présentant un coefficient de dilatation thermique inférieur à celui du substrat donneur 1' (soit également celui de la couche utile 1).

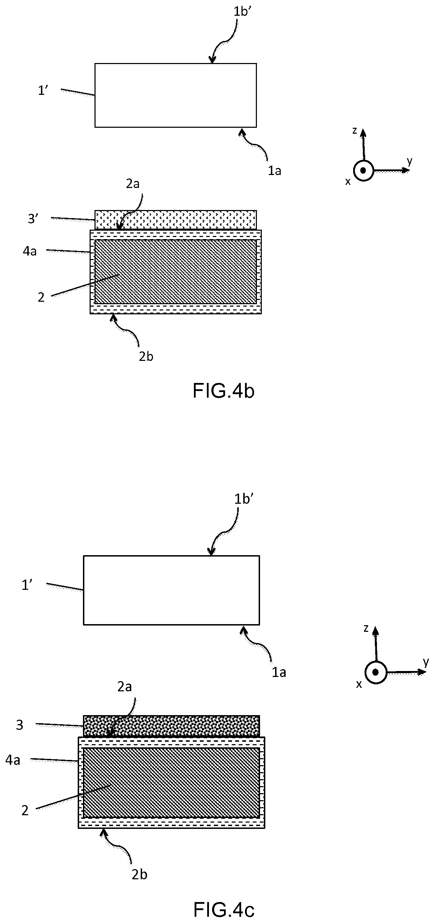

Le procédé de fabrication selon l'invention comporte une deuxième étape (notée ii)) comprenant le dépôt d'une couche 3' formée d'un mélange de poudres d'au moins un premier matériau et un deuxième matériau différent du premier, sur une première face 1a de la couche utile 1 (ou du substrat donneur 1') et/ou sur une première face 2a du substrat support 2. Dans l'exemple illustré sur la figure 4b, le dépôt de la couche 3' de mélange de poudres est effectué sur la première face 2a du substrat support 2. La couche 3' pourrait être déposée sur la première face 1a de la couche utile 1 ; elle pourrait encore être déposée sur chacune des premières faces 1a, 2a respectivement de la couche utile 1 et du substrat support 2.

Avantageusement, la première face 2a du substrat support 2 comporte une couche de protection 4a élaborée préalablement au dépôt de la couche 3' de mélange de poudres. La couche de protection 4a pourra même encapsuler complètement le substrat support 2, c'est-à-dire recouvrir sa face arrière 2b et sa tranche.

Alternativement, si la couche 3' de mélange de poudres est déposée sur la couche utile 1 (ou le substrat donneur 1'), une couche de protection sera déposée au moins sur la première face 1a de ladite couche utile 1 (ou du substrat donneur 1').

Préférentiellement, la couche de protection 4a est formée par au moins un matériau choisi parmi le nitrure de silicium, un oxynitrure de silicium, l'oxyde de silicium, l'alumine. Elle peut être élaborée par différentes techniques connues de dépôt chimique. Elle permet d'éviter ou au moins de limiter la diffusion d'impuretés contenues dans la couche 3', dans le substrat support 2 (ou la couche utile 1)

Selon une première variante de mise en œuvre, le mélange de poudres se présente sous la forme d'une pate visqueuse.

Une telle pate est habituellement obtenue en ajoutant un composé liquide, de type solvant (notamment alcool, par exemple éthanol), au mélange sec de poudres. Typiquement, les poudres utilisées contiennent des particules dont la taille moyenne est comprise entre quelques dizaines de nanomètres et quelques microns.

Alternativement, le mélange de poudres peut être intégré à une matrice de type polymère à base de silicium (PDC pour polymer-derived ceramics), apte se transformer en céramique à haute température. Notons que dans le cas d'une couche 3' avec matrice en PDC, la couche composite frittée 3 qui sera obtenue ultérieurement comprendra le premier et le deuxième matériau venant du mélange de poudres, mais également du silicium venant de la transformation en céramique de la matrice.

Le dépôt de la couche 3' formée par ledit mélange à l'étape ii) est préférentiellement réalisé par enduction centrifuge (« spin coating » ou « dip coating » selon la terminologie anglosaxonne) ou sérigraphie à travers un masque.

La viscosité de la pate est ajustée par le rapport poudres / composé liquide (solvant et/ou polymère). Elle est choisie pour permettre un dépôt uniforme de la couche 3', à des épaisseurs pouvant aller de quelques centaines de nanomètres à plusieurs microns.

Le dépôt de la couche 3' est suivi d'un traitement thermique à basses températures (par exemple entre 150°C et 400°C) permettant d'évacuer le ou les solvant(s) de la couche 3' et d'éviter tout dégazage ultérieurement au cours du procédé, notamment après l'étape d'assemblage (décrite plus loin).

Selon une deuxième variante de mise en œuvre, le mélange de poudres se présente sous une forme sèche pulvérulente et est déposé en une couche 3' sur la première face 2a du substrat support 2 (ou alternativement sur la face la du substrat donneur 1'). La mise en forme de cette couche 3' peut être réalisée par moulage par compression ou compression isostatique à chaud. Dans les deux cas, une contrainte en compression est appliquée à la couche 3' pour rendre solidaires entre elles et avec la première face 2a, les particules des poudres du mélange. Un outillage spécifique est nécessaire pour maintenir le mélange pulvérulent sur le substrat et appliquer une contrainte en compression uniforme sur toute la surface dudit substrat.

Le procédé de fabrication selon l'invention comporte une troisième étape (notée iii)) comprenant le frittage de la couche 3' formée du mélange de poudres, pour obtenir une couche composite frittée 3 solidaire de la première face 2a du substrat support 2 (figure 4c).

Le frittage s'opère habituellement à hautes températures, typiquement supérieures à 1000°C, pendant une durée pouvant aller de quelques heures à environ 24 heures. La température de frittage reste néanmoins inférieure à la température de fusion d'au moins une des poudres contenues dans la couche 3'. Sous l'effet de la chaleur, les particules des poudres se soudent entre elles, ce qui forme la cohésion de la couche composite 3 résultante. La couche composite 3 se solidarise également avec la première face 2a du substrat support 2.

Optionnellement, le frittage peut en plus être effectué sous contrainte mécanique, ce qui permet de compacter davantage la couche composite 3.

La couche composite frittée 3 est ainsi composée au moins de particules du premier et du deuxième matériau. Entre les particules, selon le niveau de compactage, il peut exister plus ou moins d'interstices vides (ou contenant la céramique issue d'une matrice PDC). Selon la distribution en taille des particules, la fraction volumique de ces interstices pourra atteindre 50%, et plus préférentiellement être maintenue inférieure à 25%, voire inférieure à 15%, notamment pour assurer une bonne tenue mécanique de la couche composite 3. Par souci de simplification, cette fraction volumique d'interstices n'a pas été prise en compte dans les modes de réalisation de la structure hybride 10 décrits précédemment ; elle pourrait être considérée comme un troisième matériau, en plus des premier et deuxième matériaux composant les particules.

L'épaisseur de la couche 3' déposée à l'étape ii) est choisie de manière à obtenir une épaisseur souhaitée de couche composite frittée 3. En effet, selon le type de couche déposée 3' (sous forme de pate avec solvant et/ou polymère ou sous forme sèche), la réduction d'épaisseur lors de l'étape de frittage sera plus ou moins importante. Une réduction en volume de la couche 3' de l'ordre de 10 à 30% peut s'opérer.

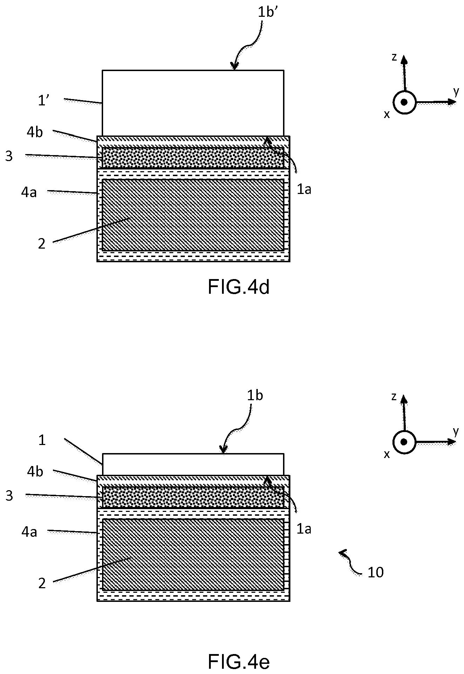

Le procédé de fabrication selon l'invention comporte une quatrième étape (notée iv)) comprenant l'assemblage de la couche utile 1 (ou du substrat donneur 1') et du substrat support 2, de sorte que la couche composite frittée 3 soit disposée entre la couche utile 1 et le substrat support 2 (figure 4d).

Préférentiellement, une couche de collage 4b est déposée sur la couche composite 3, préalablement à l'étape iv) d'assemblage. A titre d'exemple, on pourra déposer une couche d'oxyde de silicium sur la surface libre de la couche composite 3. Cette couche de collage 4b procure d'une part, une encapsulation de la couche composite frittée 3, évitant ou au moins limitant les risques de contamination entre les différentes couches de la structure hybride 10 ; d'autre part, la couche de collage 4b peut être avantageuse pour autoriser une préparation de surface classique et non spécifique à la composition de la couche composite frittée 3.

Préférentiellement, l'étape d'assemblage est réalisée par collage direct, par adhésion moléculaire des deux surfaces mises en contact : c'est-à-dire de la première face la de la couche utile 1 (ou du substrat donneur 1') et de la face libre de la couche composite 3 sur l'exemple de la figure 4c. Le principe de l'adhésion moléculaire, bien connu dans l'état de l'art ne sera pas décrit plus en détail ici.

De manière alternative, l'assemblage pourra être réalisé par ajout d'une couche de matière adhésive, ou par toute autre technique de collage adaptée à l'application visée.

Pour la plupart des procédés d'assemblage, un bon état de surface (propreté, faible rugosité, ...) des substrats à assembler sera requis.

Le procédé de fabrication selon l'invention peut comprendre en outre une cinquième étape (notée v)) comprenant l'amincissement du substrat donneur 1' jusqu'à l'épaisseur souhaitée de la couche utile 1 pour la fabrication du dispositif à ondes acoustiques (figure 4e). Cette étape pourra par exemple comprendre un rodage mécanique (« grinding ») suivi d'un polissage à sec ou mécano-chimique, permettant d'assurer un bon état de surface à la couche utile 1. Différentes séquences de nettoyage pourront être appliquées pendant ou après l'étape d'amincissement pour garantir la qualité et la propreté de la structure hybride finale 10.

L'amincissement du substrat donneur 1' pour l'obtention de la couche utile 1 pourra être opéré par toute autre technique connue, notamment le procédé Smart Cut® ou autres techniques de réalisation de couches minces.

Bien entendu, l'invention n'est pas limitée aux modes de mise en œuvre et exemples décrits, et on peut y apporter des variantes de réalisation sans sortir du cadre de l'invention tel que défini par les revendications.

## Revendications

1. Structure hybride (10) pour dispositif à ondes acoustiques de surface comprenant une couche utile (1) de matériau piézoélectrique assemblée à un substrat support (2) présentant un coefficient de dilatation thermique inférieur à celui de la couche utile (1), et une couche intermédiaire (3) située entre la couche utile (1) et le substrat support (2), la couche intermédiaire (3) étant une couche composite frittée(3), formée à partir de poudres d'au moins un premier matériau et un deuxième matériau différent du premier, la structure hybride (10) étant **caractérisée en ce que** les premier et deuxième matériaux sont choisis parmi l'oxyde de silicium, le nitrure de silicium, le silicium, le carbure de silicium, l'alumine, le germanium, le saphir, le zirconium.

2. Structure hybride (10) pour dispositif à ondes acoustiques de surface selon la revendication précédente, dans laquelle :

   • le premier matériau présente une impédance acoustique similaire à celle de la couche utile (1),
   • le rapport entre l'impédance acoustique de la couche utile (1) et l'impédance acoustique du deuxième matériau est supérieur à 2,
   • la taille moyenne des particules des poudres du premier et du deuxième matériau est supérieure ou égale au quart de la longueur d'onde du signal acoustique destiné à se propager en surface du dispositif à ondes acoustiques de surface.

3. Structure hybride (10) pour dispositif à ondes acoustiques de surface selon la revendication 1, dans laquelle :

   • le premier matériau et le deuxième matériau sont choisis de manière à former une couche d'adaptation d'impédance acoustique entre la couche utile (1) et le substrat support (2),
   • la taille moyenne des particules des poudres du premier et du deuxième matériau est inférieure au quart de la longueur d'onde du signal acoustique destiné à se propager en surface du dispositif à ondes acoustiques de surface.

4. Structure hybride (10) pour dispositif à ondes acoustiques de surface selon l'une des revendications précédentes, dans laquelle le substrat support (2) comprend un matériau choisi parmi le silicium, le verre, la silice, le saphir, l'alumine, le nitrure d'aluminium.

5. Structure hybride (10) pour dispositif à ondes acoustiques de surface selon l'une des revendications précédentes, dans laquelle la couche utile (1) comprend un matériau piézoélectrique choisi parmi le tantalate de lithium (LiTaO3), le niobate de lithium (LiNbO3), le quartz, l'oxyde de zinc (ZnO).

6. Procédé de fabrication d'une structure hybride (10) pour un dispositif à ondes acoustiques de surface **caractérisé en ce qu'**il comprend les étapes suivantes :

   i) La fourniture d'une couche utile (1) de matériau piézoélectrique et d'un substrat support (2) présentant un coefficient de dilatation thermique inférieur à celui de la couche utile (1) ;
   ii) Le dépôt d'une couche (3') formée d'un mélange de poudres d'au moins un premier matériau et un deuxième matériau différent du premier, sur une première face (1a) de la couche utile (1) et/ou sur une première face (2a) du substrat support (2), les premier et deuxième matériaux étant choisis parmi l'oxyde de silicium, le nitrure de silicium, le silicium, le carbure de silicium, l'alumine, le germanium, le saphir, le zirconium ;

iii) Le frittage de la couche (3') formée du mélange de poudres pour obtenir une couche composite frittée (3) solidaire de la première face (1a) de la couche utile (1) et/ou de la première face (2a) du substrat support (2) ;

iv) L'assemblage de la couche utile (1) et du substrat support (2), de sorte que la couche composite (3) soit disposée entre la couche utile (1) et le substrat support (2) .

7. Procédé de fabrication d'une structure hybride (10) pour un dispositif à ondes acoustiques de surface selon la revendication précédente, dans lequel la première face (1a) de la couche utile (1) et/ou la première face (2a) du substrat support (2) comporte une couche de protection (4, 4a), préalablement au dépôt de la couche (3') formée du mélange de poudres de l'étape ii).

8. Procédé de fabrication d'une structure hybride (10) pour un dispositif à ondes acoustiques de surface selon la revendication précédente, dans lequel la couche de protection (4, 4a) est formée par au moins un matériau choisi parmi le nitrure de silicium, un oxynitrure de silicium, un oxyde de silicium et l'alumine.

9. Procédé de fabrication d'une structure hybride (10) pour un dispositif à ondes acoustiques de surface selon l'une des trois revendications précédentes, dans lequel le mélange de poudres se présente sous la forme d'une pate visqueuse, et le dépôt de la couche (3') formée par ledit mélange à l'étape ii) est réalisé par enduction centrifuge.

10. Procédé de fabrication d'une structure hybride (10) pour un dispositif à ondes acoustiques de surface selon la revendication précédente, dans lequel le dépôt de la couche (3') formée par le mélange de poudres est suivi d'un traitement thermique à basse température pour évacuer au moins un composant liquide de la pate visqueuse.

11. Procédé de fabrication d'une structure hybride (10) pour un dispositif à ondes acoustiques de surface selon l'une des cinq revendications précédentes, dans lequel une couche de collage (4b) est déposée sur la couche composite (3), préalablement à l'étape iv) d'assemblage.

12. Procédé de fabrication d'une structure hybride (10) pour un dispositif à ondes acoustiques de surface selon l'une des six revendications précédentes, dans lequel la couche utile (1) fournie à l'étape i) est un substrat donneur (1') de matériau piézoélectrique.

13. Procédé de fabrication d'une structure hybride (10) pour un dispositif à ondes acoustiques de surface selon la revendication précédente, comprenant une étape v) d'amincissement du substrat donneur (1') jusqu'à l'épaisseur souhaitée de la couche utile (1) pour la fabrication du dispositif à ondes acoustiques.

**Patentansprüche**

1. Hybridstruktur (10) für eine Oberflächenwellenvorrichtung, die eine Nutzschicht (1) aus piezoelektrischem Material, die mit einem Trägersubstrat (2) zusammengefügt ist, das einen Wärmeausdehnungskoeffizienten aufweist, der kleiner als der der Nutzschicht (1) ist, und eine Zwischenschicht (3) umfasst, die zwischen der Nutzschicht (1) und dem Trägersubstrat (2) liegt, wobei die Zwischenschicht (3) eine Sinterverbundschicht (3) ist, die aus Pulvern aus wenigstens einem ersten Material und einem sich von dem ersten unterscheidenden zweiten Material ausgebildet wurde, wobei die Hybridstruktur (10) **dadurch gekennzeichnet ist, dass** das erste und das zweite Material aus Siliziumoxid, Siliziumnitrid, Silizium, Siliziumkarbid, Aluminiumoxid, Germanium, Saphir, Zirkonium ausgewählt sind.

2. Hybridstruktur (10) für eine Oberflächenwellenvorrichtung nach dem vorhergehenden Anspruch, wobei:

• das erste Material eine akustische Impedanz aufweist, die der der Nutzschicht (1) ähnlich ist,

• das Verhältnis zwischen der akustischen Impedanz der Nutzschicht (1) und der akustischen Impedanz des zweiten Materials größer als 2 ist,

• die durchschnittliche Größe der Pulverpartikel des ersten und des zweiten Materials größer als oder gleich einem Viertel der Wellenlänge des akustischen Signals ist, das dafür bestimmt ist, sich an der Oberfläche der Oberflächenwellenvorrichtung auszubreiten.

3. Hybridstruktur (10) für eine Oberflächenwellenvorrichtung nach Anspruch 1, wobei:

• das erste Material und das zweite Material so ausgewählt sind, dass sie eine Schicht für eine Anpassung der akustischen Impedanz zwischen der Nutzschicht (1) und dem Trägersubstrat (2) bilden,
• die durchschnittliche Größe der Pulverpartikel des ersten und des zweiten Materials kleiner als ein Viertel der Wellenlänge des akustischen Signals ist, das dafür bestimmt ist, sich an der Oberfläche der Oberflächenwellenvorrichtung auszubreiten.

4. Hybridstruktur (10) für eine Oberflächenwellenvorrichtung nach einem der vorhergehenden Ansprüche, wobei das Trägersubstrat (2) ein Material umfasst, das aus Silizium, Glas, Siliziumdioxid, Saphir, Aluminiumoxid, Aluminiumnitrid ausgewählt ist.

5. Hybridstruktur (10) für eine Oberflächenwellenvorrichtung nach einem der vorhergehenden Ansprüche, wobei die Nutzschicht (1) ein piezoelektrisches Material umfasst, das aus Lithiumtantalat (LiTaO3), Lithiumniobat (LiNbO3), Quarz, Zinkoxid (ZnO) ausgewählt ist.

6. Verfahren zum Herstellen einer Hybridstruktur (10) für eine Oberflächenwellenvorrichtung, **dadurch gekennzeichnet, dass** es die folgenden Schritte umfasst:

   i. Bereitstellen einer Nutzschicht (1) aus piezoelektrischem Material und eines Trägersubstrats (2), das einen Wärmeausdehnungskoeffizienten aufweist, der kleiner als der der Nutzschicht (1) ist;
   ii. Aufbringen einer Schicht (3'), die aus einer Pulvermischung aus wenigstens einem ersten Material und einem sich von dem ersten unterscheidenden zweiten Material ausgebildet wird, auf eine erste Seite (1a) der Nutzschicht (1) und/oder auf eine erste Seite (2a) des Trägersubstrats (2), wobei das erste und das zweite Material aus Siliziumoxid, Siliziumnitrid, Silizium, Siliziumkarbid, Aluminiumoxid, Germanium, Saphir, Zirkonium ausgewählt sind;
   iii. Sintern der Schicht (3'), die aus der Pulvermischung ausgebildet wurde, so dass eine Sinterverbundschicht (3) erhalten wird, die mit der ersten Seite (1a) der Nutzschicht (1) und/oder der ersten Seite (2a) des Trägersubstrats (2) fest verbunden ist;
   iv. Zusammenfügen der Nutzschicht (1) und des Trägersubstrats (2), so dass die Verbundschicht (3) zwischen der Nutzschicht (1) und dem Trägersubstrat (2) angeordnet ist.

7. Verfahren zum Herstellen einer Hybridstruktur (10) für eine Oberflächenwellenvorrichtung nach dem vorhergehenden Anspruch, wobei die erste Seite (1a) der Nutzschicht (1) und/oder die erste Seite (2a) des Trägersubstrats (2) eine Schutzschicht (4, 4a) aufweist, die vor dem Aufbringen der Schicht (3') aus der Pulvermischung aus Schritt ii) ausgebildet wurde.

8. Verfahren zum Herstellen einer Hybridstruktur (10) für eine Oberflächenwellenvorrichtung nach dem vorhergehenden Anspruch, wobei die Schutzschicht (4, 4a) durch wenigstens ein Material ausgebildet wird, das aus Siliziumnitrid, Siliziumoxynitrid, Siliziumoxid und Aluminiumoxid ausgewählt ist.

9. Verfahren zum Herstellen einer Hybridstruktur (10) für eine Oberflächenwellenvorrichtung nach einem der drei vorhergehenden Ansprüche, wobei die Pulvermischung in Form einer dickflüssigen Paste vorliegt und das Aufbringen der Schicht (3'), die durch die Mischung in Schritt ii) ausgebildet wird, durch Schleuderbeschichtung ausgeführt wird.

10. Verfahren zum Herstellen einer Hybridstruktur (10) für eine Oberflächenwellenvorrichtung nach dem vorhergehenden Anspruch, wobei auf das Aufbringen der Schicht (3'), die durch die Pulvermischung ausgebildet wird, eine Wärmebehandlung bei niedriger Temperatur zum Ausscheiden wenigstens einer flüssigen Komponente der dickflüssigen Paste folgt.

11. Verfahren zum Herstellen einer Hybridstruktur (10) für eine Oberflächenwellenvorrichtung nach einem der fünf vorhergehenden Ansprüche, wobei eine Klebeschicht (4b) auf der Verbundschicht (3) vor Schritt iv) des Zusammenfügens aufgebracht wird.

12. Verfahren zum Herstellen einer Hybridstruktur (10) für eine Oberflächenwellenvorrichtung nach einem der sechs vorhergehenden Ansprüche, wobei die Nutzschicht (1), die in Schritt i) bereitgestellt wird, ein Donorsubstrat (1') aus piezoelektrischem Material ist.

13. Verfahren zum Herstellen einer Hybridstruktur (10) für eine Oberflächenwellenvorrichtung nach dem vorhergehenden Anspruch, das einen Schritt v) eines Verdünnens des Donorsubstrats (1') auf die für das Herstellen der Schallwellenvorrichtung gewünschte Dicke der Nutzschicht (1) umfasst.

**Claims**

1. Hybrid structure (10) for a surface acoustic wave device, which structure comprises a useful layer (1) which is made of piezoelectric material and is joined to a support substrate (2) having a coefficient of thermal expansion that is lower than that of the useful layer (1), and an intermediate layer (3) which is located between the useful layer (1) and the support substrate (2), the intermediate layer (3) being a sintered composite layer (3) which is made from powders of at least a first material and a second material different from the first material, the hybrid structure (10) being **characterized in that** the first and second materials are selected from silicon oxide, silicon nitride, silicon, silicon carbide, alumina, germanium, sapphire and zirconium.

2. Hybrid structure (10) for a surface acoustic wave device according to the preceding claim, wherein:

   the first material has an acoustic impedance which is similar to that of the useful layer (1),
   the ratio between the acoustic impedance of the useful layer (1) and the acoustic impedance of the second material is greater than 2,
   the average particle size of the powders of the first and of the second material is greater than or equal to a quarter of the wavelength of the acoustic signal which is intended to propagate on the surface of the surface acoustic wave device.

3. Hybrid structure (10) for a surface acoustic wave device according to claim 1, wherein:

   the first material and the second material are selected so as to form an acoustic impedance matching layer between the useful layer (1) and the support substrate (2),
   the average particle size of the powders of the first and of the second material is smaller than a quarter of the wavelength of the acoustic signal which is intended to propagate on the surface of the surface acoustic wave device.

4. Hybrid structure (10) for a surface acoustic wave device according to any of the preceding claims, wherein the support substrate (2) comprises a material selected from silicon, glass, silica, sapphire, alumina and aluminum nitride.

5. Hybrid structure (10) for a surface acoustic wave device according to any of the preceding claims, wherein the useful layer (1) comprises a piezoelectric material selected from lithium tantalate (LiTaO3), lithium niobate (LiNbO3), quartz and zinc oxide (ZnO).

6. Method for producing a hybrid structure (10) for a surface acoustic wave device, **characterized in that** it comprises the following steps:

   providing a useful layer (1) made of piezoelectric material and a support substrate (2) having a coefficient of thermal expansion that is lower than that of the useful layer (1);
   depositing a layer (3') which is made from a mixture of powders of at least a first material and a second material different from the first material on a first surface (1a) of the useful layer (1) and/or on a first surface (2a) of the support substrate (2), the first and second materials being selected from silicon oxide, silicon nitride, silicon, silicon carbide, alumina, germanium, sapphire and zirconium;
   sintering the layer (3') which is made from the mixture of powders in order to obtain a sintered composite layer (3) which is secured to the first surface (1a) of the useful layer (1) and/or to the first surface (2a) of the substrate support (2);
   joining the useful layer (1) and the support substrate (2) so that the composite layer (3) is arranged between the useful layer (1) and the support substrate (2).

7. Method for producing a hybrid structure (10) for a surface acoustic wave device according to the preceding claim, wherein the first surface (1a) of the useful layer (1) and/or the first surface (2a) of the substrate support (2) comprises a protective layer (4, 4a), prior to depositing the layer (3') which is made from the mixture of powders in step ii).

8. Method for producing a hybrid structure (10) for a surface acoustic wave device according to the preceding claim, wherein the protective layer (4, 4a) is made from at least one material selected from silicon nitride, a silicon oxynitride, a silicon oxide and alumina.

9.  Method for producing a hybrid structure (10) for a surface acoustic wave device according to any of the three preceding claims, wherein the mixture of powders is in the form of a viscous paste, and the deposition of the layer (3') which is made from said mixture in step ii) is achieved by centrifugal coating.

10. Method for producing a hybrid structure (10) for a surface acoustic wave device according to the preceding claim, wherein the deposition of the layer (3') which is made from the mixture of powders is followed by a low-temperature heat treatment to remove at least one liquid component from the viscous paste.

11. Method for producing a hybrid structure (10) for a surface acoustic wave device according to any of the five preceding claims, wherein an adhesive layer (4b) is deposited on the composite layer (3), prior to joining step iv).

12. Method for producing a hybrid structure (10) for a surface acoustic wave device according to any of the six preceding claims, wherein the useful layer (1) provided in step i) is a donor substrate (1') of piezoelectric material.

13. Method for producing a hybrid structure (10) for a surface acoustic wave device according to the preceding claim, comprising a step v) of thinning the donor substrate (1') to the desired thickness of the useful layer (1) in order to produce the acoustic wave device.

FIG.1

| Matériau | Vitesse acoustique onde longitudinale (VL) (m/s) | Densité ρ (g/cm3) | Impédance acoustique (x1E6) (kg/(m2.s)) | Resistivité (ohm.cm) | Permittivité |
|---|---|---|---|---|---|
| SiO2 | 6000 | 2,2 | 13,20 | 1,00E+17 | 3,9 |
| Si | 8430 | 2,34 | 19,70 | 250000 | 11,7 |
| Ge | 5410 | 5,47 | 29,60 | | |
| Si3N4 | 9900 | 2,20 | 21,78 | 1e10 - 1e15 | 9.5-10.5 |
| SiC | 13000 | 13,80 | 91,80 | 1E2-1E6 | |
| Al2O3 | 10520 | 3,86 | 40,60 | >1E14 | 9,8 |
| Sapphire, aluminium oxide | 11100 | 3,99 | 44,30 | | |
| Zirconium | 4650 | 6,48 | 30,10 | | |

TAB.1a

| Matériau | Vitesse acoustique onde longitudinale (VL) (m/s) | Densité ρ (g/cm3) | Impédance acoustique (x1E6) (kg/(m2.s)) |
|---|---|---|---|
| AlN | 11000 | 3,27 | 36,00 |
| LTO | 6000 | 7,46 | 44,76 |
| LNO | 7000 | 4,64 | 32,48 |

TAB.1b

FIG.2a

FIG.2b

20    1b

1
4
3
4

2

10

z
y
x

FIG.3

1b'

1'

1a

z
y
x

2a

2

2b

FIG.4a

1b′

1′

1a

2a

3′

4a

2

2b

z

y

x

FIG.4b

1b′

1′

1a

2a

3

4a

2

2b

z

y

x

FIG.4c

FIG.4d

FIG.4e

**EP 3 776 677 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20140091677 A

**Littérature non-brevet citée dans la description**

- **K.HASHIMOTO ; M.KADOTA et al.** Recent development of temperature compensated SAW devices. *IEEE Ultrason. Symp.,* 2011, 79-86

- **B.P.ABBOTT et al.** Characterization of bonded wafer for RF filters with reduced TCF. *Proc 2005 IEEE International Ultrasonics Symposium,* 19 Septembre 2005, 926-929